# EUROPEAN PATENT SPECIFICATION

(11) **EP 0 689 063 B1**
(45) Date of publication and mention of the grant of the patent: **23.01.2002**
(21) Application number: 95109468.9
(22) Date of filing: 19.06.1995
(51) Int. Cl.: G01T 1/29, H01J 37/244, G01T 1/28

(54) **Electron detector with high back-scattered electron acceptance for particle beam apparatus**
Elektron-Detektor mit grosser Akzeptanz für rückgestreute Elektronen für einen Teilchenstrahl-Apparat
Détecteur d'électrons avec haute acceptation d'électrons rétrodiffusés pour appareil à rayons de particules

(30) Priority: 20.06.1994 US 262285
(43) Date of publication of application: 27.12.1995
(73) Proprietor: Applied Materials Israel Ltd., 70451 Nes Ziona (IL)
(72) Inventor: Litman, Alon, 74073 Nes Ziona (IL); Goldenstein, Alexander, 58492 Holon (IL); Rogers, Steven R., 76880 D.N. Emek Sorek (IL)
(74) Representative: Zimmermann, Gerd Heinrich

(56) References cited:
- US-A- 3 896 308
- US-A- 4 246 479
- US-A- 4 933 552
- US-A- 4 958 079

## Description

### Field and Background of the Invention

The present invention relates to particle beam apparatus in general and in particular to electron multiplier detectors with high backscattered electron acceptance.

Particle beam apparatus, such as the scanning electron microscope, electron beam lithography equipment, ion beam lithography equipment, and the like are used in wide range of application. In principle, particle beam apparatus scans the surface of a specimen with an energetic particle beam. The impact of the particle beam on the surface of the specimen causes a release of electrons. In accordance with accepted nomenclature, electrons released with energies exceeding 50 eV are referred to as backscattered electrons (BSEs) while electrons released with energies of 50 eV or less are referred to as secondary electrons (SEs). For a particle beam of approximately 1000 eV, the released electrons are typically divided equally between BSEs and SEs. As used in the following description and claims, the term "backscattered acceptance" refers to the overall detection efficiency of backscattered electrons that arrive (or are "accepted" by) a detector. The term "areal detection efficiency", as used in the description hereinafter, pertains to the geometrical area of a detector which is active in detecting electrons. In a microchannel plate detector, the detector surface is covered with holes. The holes are the active area. Typically, only 60% of the area is in the holes, while the remaining 40% (which is the area between holes) is inactive.

It is well known that backscattered electrons contain material contrast information while secondary electrons contain topographical information.

Particular applications of particle beam apparatus which require high backscattered electron acceptance include inspection of VLSI devices, viewing the bottoms of deep trenches and contact holes in semiconductor materials, and the like.

Early implementation of electron detectors for detecting backscattered electrons are described in a book entitled "Image Formation in Low Voltage Scanning Electron Microscopy" by L. Reimer in SPIE Optical Engineering Press, Bellingham, Washington, USA, 1993,pp. 31-40. Broadly speaking, the electron detectors include a conversion plate for absorbing BSEs and emitting SEs which are, in turn, detected by an Everhart-Thomley scintillator detector. These electron detectors suffer from limited BSE acceptance because the scintillators are typically maintained at a potential of 5 to 10 kV requiring that the detectors be positioned far from the particle beam to prevent large beam deflections and aberrations.

Later implementations of electron detectors for detecting backscattered electrons from a specimen utilize electron detectors fashioned as a microchannel plate electron multiplier or a solid-state electron multiplier. An apparatus including such an electron detector is disclosed in US Patent No. 4,933,552 to Lee entitled "Inspection System Utilizing Retarding Field Back Scattered Electron Collection". Here, a particle beam is columnated and directed through a bias plate and annular detector at a specimen held at a negative bias with respect to the plate and the detector. The negative bias is selected so that the incident beam strikes the specimen at the crossover energy so that minimum specimen charging occurs. The negative bias also effects spatial separation between SEs and those BSEs having a large transverse velocity component in the plane of the detector.

Note, that at the cross-over energy the number of electrons scattered from the specimen is equal to the number entering the specimen from the primary electron beam. This arrangement suffers from two main disadvantages. First, the detector has low acceptance of BSEs with small transverse velocity components which, in the case of a particle beam directed at normal incidence to a specimen, can be a substantial fraction of the total BSE yield. In fact, in this instance, the transverse velocity distribution of the BSEs emitted by the specimen has its peak value at zero transverse velocity. And second, in practice, it is difficult to maintain highly insulating specimens at a uniform negative potential while scanning them with a charged particle beam.

Other implementations utilizing microchannel plate or solid state electron multipliers are described in an article entitled "Low-profile high efficiency microchannel plate detector system for scanning electron microscopy application," by Michael T. Postek and William J. Keery in Reviews of Scientific Instruments, vol. 61, no.6, June, 1990, pp. 1648 - 1657. Here, the particle beam passes through a beam shielding tube on its way to the specimen for preventing deviation and aberration. Hence, the focal point of the beam is directly under the beam shielding tube. When used as a BSE detector, the surface of the electron multiplier is maintained at a potential of -50 V or less with respect to the specimen which is typically grounded.

This implementation also suffers from low BSE acceptance for a number of reasons. First, the electron multiplier only detects BSEs with energies greater than its own potential. Second, many of the BSEs, referred to hereinbelow as Type A BSEs, fail to be detected because they impinge between the active channels of the electron multiplier. And finally, a smaller number of BSEs, referred to hereinbelow as Type B BSEs are also not detected because they impinge on the beam shielding tube.

These undetected BSEs cause a considerable deterioration in the quality of images rendered by the electron detector because they constitute a meaningful percentage of the total yield of BSEs. As described in the article entitled "Areal detection efficiency of channel electron multiplier arrays" by J. A. Panitz and J.A. Foesch in Rev. Sci Instrum VOL 47, No. 1, January 1976, the areal detection efficiency of a microchannel plate electron multiplier is typically only about 60%. Thus, Type A BSEs constitute approximately 40% of the total BSE yield. Type B BSBs are usually less numerous, but they often constitute a large fraction of the BSEs in applications where electron emission by the specimen is highly collimated along the particle beam axis.

US 3,896,308 concerns a detector for electron microscopes. It essentially consists of a channel plate sandwiched between two electrodes across which a potential can be applied. It further comprises a grid of conductive material to control the field distribution in the specimen region. One or more detector electrodes are mounted onto the channel plate to receive electrons transmitted through the channel plate.

Document US-A-4 958 079 discloses an electron detector comprising a micro channel plate having an input surface towards which backscattered elections are accelerated. A grid is arranged between the micro channel plate and a specimen. In one embodiment, the grid is at negative potential with respect to the specimen and also with respect to the input surface of the micro channel plate.

There is therefore a need for an electron detector having a high backscattered acceptance without suffering from the aforementioned deficiencies.

### SUMMARY OF THE INVENTION

The main object of the present invention is to provide an electron detector having a high backscattered electron acceptance.

Hence, there is provided according to the teachings of the present invention, an electron detector having a high backscattered electron acceptance of backscattered electrons emitted from a specimen, the electron detector comprising: (a) an electron multiplier having an input surface for collecting high energy backscattered electrons, the input surface releasing Type A secondary electrons on impingement of Type A backscattered electrons thereon, the Type A secondary electrons having trajectories away from the input surface; (b) a first electrode deployed between the electron multiplier and the specimen, the first electrode being biased at a negative potential with respect to the specimen so as to generate a first electric field for retarding low energy secondary electrons emitted by the specimen from reaching the electron multiplier, and thereby enabling passage of the high energy backscattered electrons emitted by the specimen towards the electron multiplier; and (c) a second electrode deployed between the electron multiplier and the first electrode, the second electrode being biased at a negative potential with respect to the input surface and spaced from the input surface at a distance selected so as to generate a second electric field for substantially inverting the trajectories of the Type A secondary electrons towards the input surface such that the input surface collects the Type A secondary electrons.

According to a further embodiment of the present invention, the first electrode and the second electrode are combined as a single electrode deployed between the electron multiplier and the specimen, the electrode being biased at a negative potential with respect to the input surface and to the specimen, the electrode generating a first electric field for retarding low energy secondary electrons emitted by the specimen from reaching the electron multiplier, and thereby enabling passage of the high energy backscattered electrons emitted by the specimen towards the electron multiplier, and the electrode being spaced from the input surface at a distance selected so as to generate a second electric field for substantially inverting the trajectories of the Type A secondary electrons towards the input surface such that the input surface collects the Type A secondary electrons.

According to a preferred feature of the present invention, the first electrode is annular having an aperture selected for passing therethrough a pre-determined solid angle of backscattered electrons for impingement on the electron multiplier.

According to another preferred feature of the present invention, the second electrode is annular having an aperture selected for passing therethrough a pre-determined solid angle of backscattered electrons for impingement on the electron multiplier.

According to another preferred feature of the present invention, the electron detector further comprising a third electrode deployed between the second electrode and the specimen, the third electrode having a potential so as to act as a Faraday cage for the electron detector.

According to another preferred feature of the present invention, the electron detector further comprising a beam shielding tube for the passage therethrough of a particle beam toward the specimen, the beam shielding tube releasing Type B secondary electrons on impingement of Type B backscattered electrons thereon, the Type B secondary electrons having trajectories away from the beam shielding tube, the second electric field substantially inverting the trajectories of the Type B secondary electrons towards the input surface such that the input surface collects the Type B secondary electrons.

According to another preferred feature of the present invention, the beam shielding tube has a beveled end.

According to another preferred feature of the present invention, the beam shielding tube is fabricated from a material having a secondary electron emission coefficient of greater than unity.

According to another preferred feature of the present invention, particle beam apparatus including an electron detector for detecting backscattered electrons emitted from a specimen as claimed in claim 1.

### BRIEF DESCRIPTION OF THE DRAWINGS

The invention is herein described, by way of example only, with reference to the accompanying drawings, wherein:
FIG. 1 is a schematic view of a first embodiment of an electron detector having a high backscattered electron acceptance deployed exterior to the optical column of particle beam apparatus;
FIG. 2 illustrates the inversion of the trajectories of secondary electrons, produced by Type A BSEs impinging on the input surface of the electron multiplier, toward the input surface of the electron multiplier by an electric field prevailing within the electron detector;
FIG. 3 illustrates the inversion of the trajectories of secondary electrons, produced by Type B BSEs impinging on the beam shielding tube of the electron detector, toward the input surface of the electron multiplier by an electric field prevailing within the electron detector;
FIG. 4 illustrates representative electric potential fields prevailing within the electron detector of Figure 1 according to the teachings of the present invention;
FIG. 5 is a schematic view of a second embodiment of an electron detector having a high backscattered electron acceptance deployed exterior to the optical column of particle beam apparatus;
FIG. 6 illustrates representative electric potential fields prevailing within the electron detector of Figure 5 according to the teachings of the present invention;
FIG. 7 is a schematic view of the electron detector including a third electrode for shielding a specimen from the electric field generated by the first electrode of the electron detector; and
FIG. 8 is a schematic view of an electron detector deployed within the optical column of particle beam apparatus.

### DESCRIPTION OF THE PREFERRED EMBODIMENTS

The present invention is of an electron detector having a high backscattered electron acceptance.

The principles and operation of the electron detector according to the present invention may be better understood with reference to the drawings and the accompanying description.

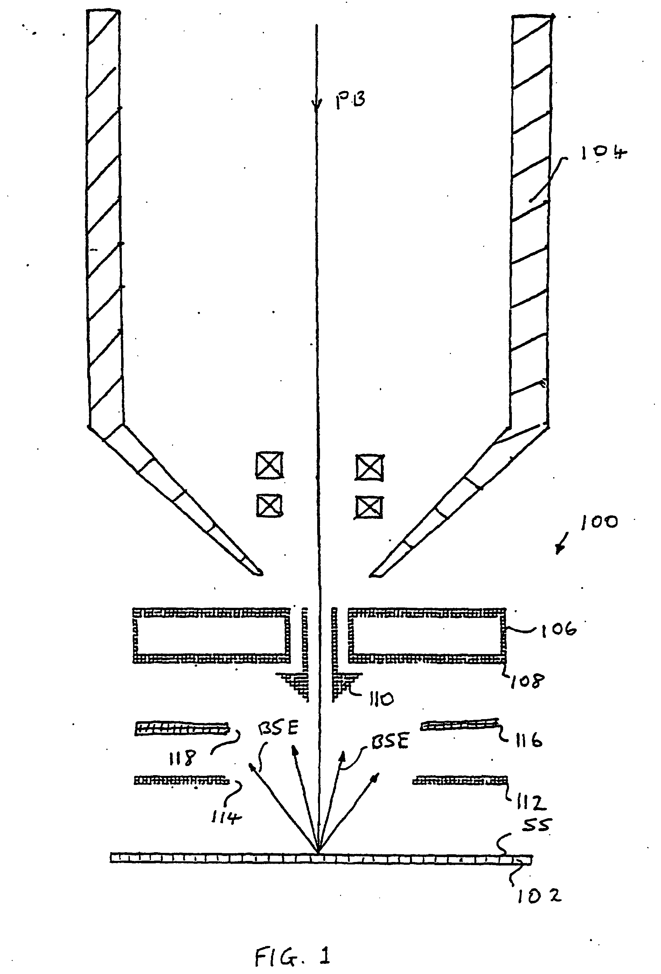

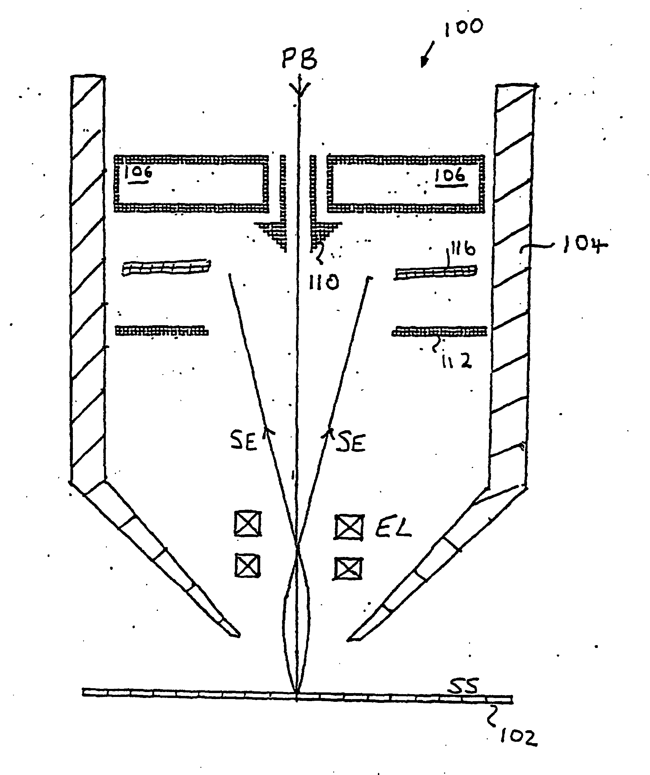

Referring now to the drawings, Figure 1 shows a first embodiment of an electron detector, generally designated **100,** constructed and operative according to the teachings of the present invention, having a high backscattered electron acceptance of backscattered electrons denoted BSE emitted by a specimen **102** through the action of a particle beam PB provided by a particle beam apparatus **104.** In the configuration shown, electron detector **100** is deployed exterior to particle beam apparatus **104** while, in an alternative configuration shown in Figure 8, electron detector **100** is deployed within the optical column of particle beam apparatus **104.**

In principle, particle beam apparatus **104** provides a particle beam PB having energies typically greater than 200 eV for evaluating top surface SS of specimen **102**. Particle beam PB impinges on surface SS of specimen **102** and causes electrons to be released therefrom. The released electrons have energies ranging from zero to the PB kinetic energy. In accordance with accepted nomenclature, the electrons released with energies exceeding 50 eV are referred to as backscattered electrons (BSEs) while the electrons released with energies of 50 eV or less are referred to as secondary electrons (SEs).

Electron detector **100** includes a generally annular electron multiplier **106** having an input surface **108** for capturing backscattered electrons and a beam shielding tube **110** passing through electron multiplier **106** and extending forward of input surface **108** for preventing deviation of particle beam PB on its way to specimen **102** from particle beam apparatus **104**. Electron multiplier **106** can be fabricated as a microchannel electron multiplier, a solid-state electron multiplier, and the like.

It is a feature of the present invention that electron detector **100** requires an energy filter for retarding secondary electrons emitted by specimen **102** such that only electrons above a certain threshold, or in other words, the backscattered electrons reach electron multiplier **106**. This is best achieved by providing a generally annular electrode **112** biased at a negative potential with respect to specimen **102** such that the potential difference between the center of its aperture **114** and specimen **102** is -50V or less.

Furthermore, in accordance with the motivation for electron detector **100**, electron detector **100** detects not only those backscattered electrons which are captured by input surface **108** of electron multiplier **106** directly on their impingement thereon but also those backscattered electrons which are not captured directly. These backscattered electrons fall into two categories as follows: First, the backscattered electrons which impinge on the inactive portion of input surface **108** of electron multiplier **106** referred to hereinafter as Type A BSEs. And second, those backscattered electrons which impinge on beam shielding tube **110** referred to hereinafter as Type B BSEs.

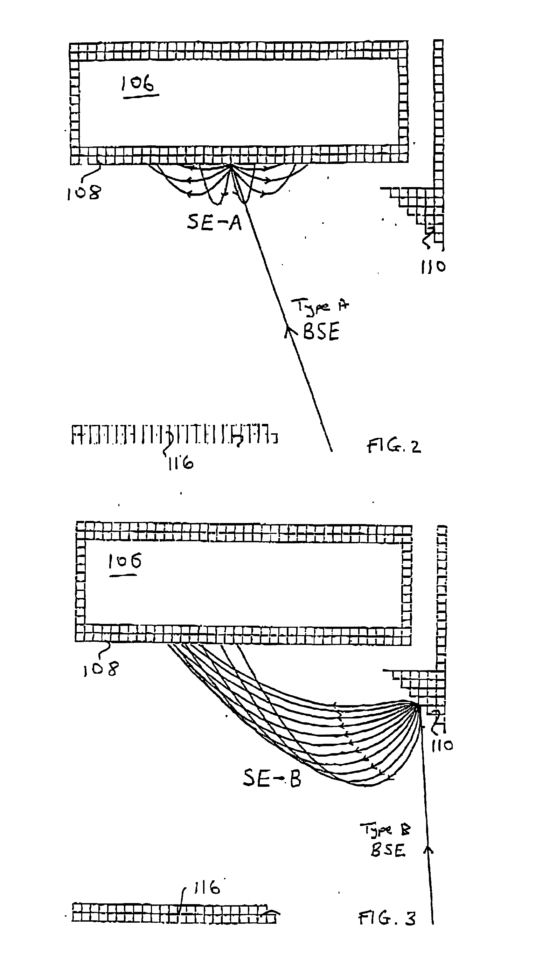

In practice, this is achieved by electron detector **100** detecting the low energy secondary electrons denoted SE-A which are released when the Type A BSEs impinge on input surface **108** and the low energy secondary electrons denoted SE-B which are released when the Type B BSEs impinge on beam shielding tube **110**. It can be readily appreciated that both the SE-As and the SE-Bs have trajectories away from input surface **108** and therefore their capture by input surface **108** can only be achieved by an electric field which substantially inverts their trajectories towards input surface **108** as shown in Figures 2 and 3, respectively.

Such an electric field is best provided by a generally annular electrode **116**, having an aperture **118**, deployed between input surface **108** and electrode **112** while the potentials conducive to generating the electric field are as follows: First, input surface **108** of electrode multiplier **106** is required to be biased at a positive potential with respect to electrode **116.** Second, input surface **108** of electron multiplier **106** is preferably biased at a positive potential with respect to beam shielding tube **110.** And third, beam shielding tube **110** is preferably biased at substantially the same potential as or at a positive potential with respect to electrode **116**. It should be noted that input surface **108** of electron multiplier **106** can be biased at a positive potential with respect to specimen **102,** at substantially the same potential as specimen **102** or at a negative potential with respect to specimen **102** depending on the particular application in hand.

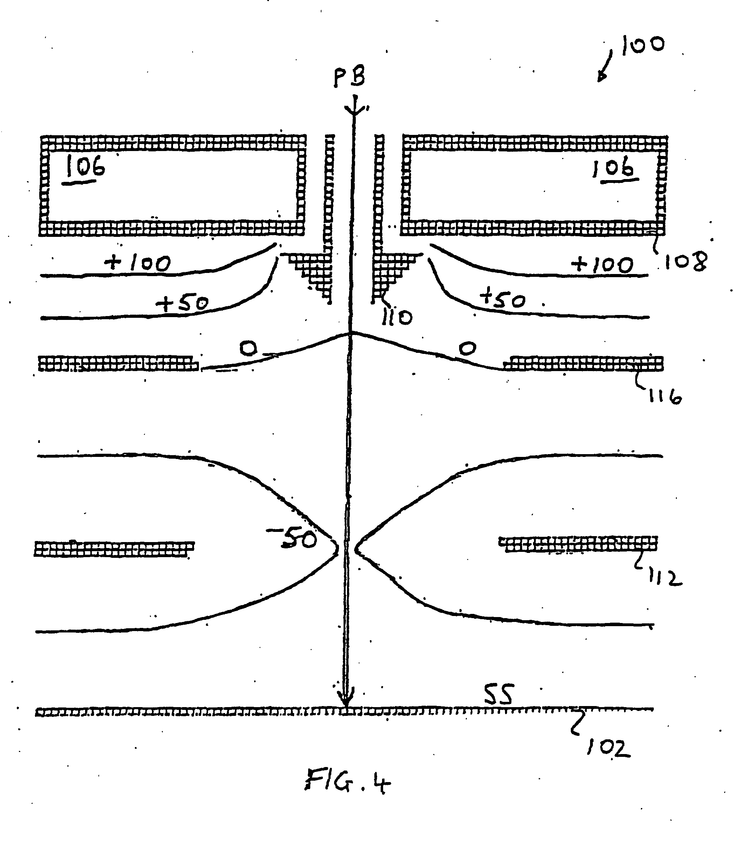

Turning now to Figure 4, for the sake of exposition, the electric fields prevailing within electron detector **100** which achieve, on the one hand, the retarding of the secondary electrons emitted from specimen **102** and, on the other hand, the inverting of the trajectories of the SE-AS and the SE-BS are shown for the following representative voltages: electrode **112** at a voltage of 110 V, input surface **108** of electron multiplier **106** at a voltage of +150 V, and surface SS of specimen **102**, beam shielding tube **110** and electrode **116** at a voltage of 0 V. It can be readily appreciated by those proficient in the art that a wide range of voltages and voltage differentials can be equally well employed to achieve the required electric fields as described hereinabove.

It is a further feature of the present invention that either electrode **112** or electrode **116** can be employed as a spatial filter by selecting the diameters of their respective apertures **114** or **118** such that only a pre-determined solid angle of backscattered electrons can pass therethrough so as to reach electron multiplier **106**. Incidentally, the trajectories of BSEs, typically having energies of several hundred electron volts are almost undeflected as they pass through electrodes **112** and **116**.

It is a still further feature of the present invention that the probability of detecting Type B BSEs is significantly increased by proper design of beam shielding tube **110.** In particular, the emission of secondary electrons by impingement of Type B BSEs on beam shielding tube **110** is enhanced by beveling its end causing the maximum of the Lambertain angular distribution of the secondary electrons to be inclined toward the direction of electron multiplier **106**. Furthermore, beam shielding tube **110** can be fabricated from material with a secondary electron emission coefficient of greater than unity. Such materials have been widely studied in connection with photomultiplier devices and are described in detail in the article entitled "Secondary Electron Emission" by Kenneth G. McKay in L. Martin (ed), Advances in Electronics, vol. Academic Press Inc. New York, NY 1948, pp. 65-130 which is incorporated by reference as if it were fully set forth herein.

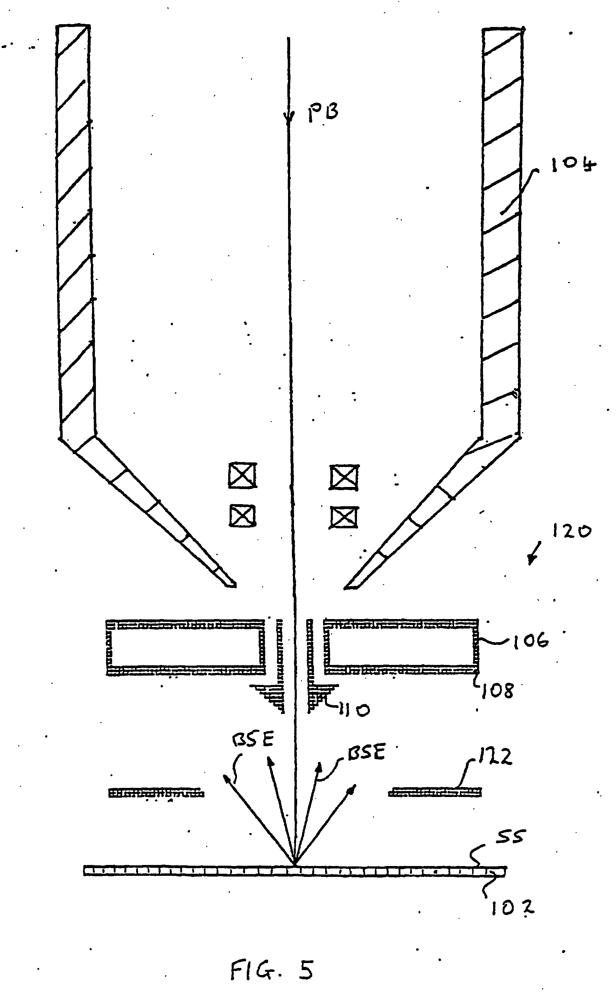

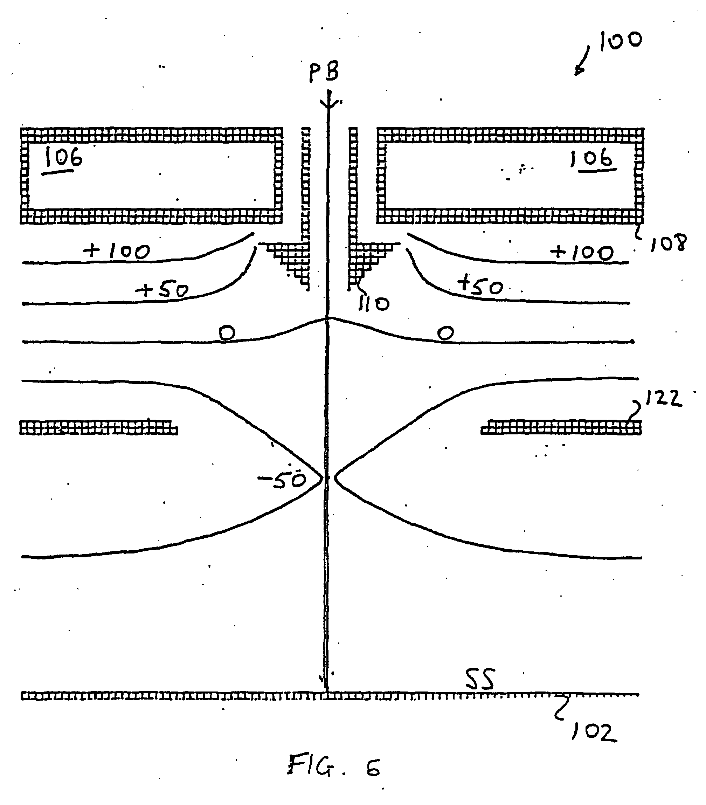

Turning now to Figures 5 and 6, the Figures show a second embodiment of electron detector, generally designated **120**, constructed and operative according to the teachings of the present invention, having a high backscattered electron acceptance. Electron detector **120** is similar in construction and operation to electron detector **100** and therefore similar elements are likewise numbered. The main difference between electron detector **120** and electron detector **100** is that electron detector **120** employs a single electrode **122** to replace electrodes **112** and **116**.

For the sake of exposition, the electric fields prevailing within electron detector **120** which achieve, on the one hand, the retarding of the secondary electrons emitted from specimen **102** and, on the other hand, the substantially inverting of the trajectories of the SE-As and the SE-BS are shown for the following representative voltages: electrode **122** at a voltage of -150 V, input surface **108** of electron multiplier **106** at a voltage of +150 V, and surface SS of specimen **102** and beam shielding tube **110** at a voltage of 0 V. As before, it can be readily appreciated by those proficient in the art that a wide range of voltages and voltage differentials can be equally well employed to achieve the required electric fields as described hereinabove.

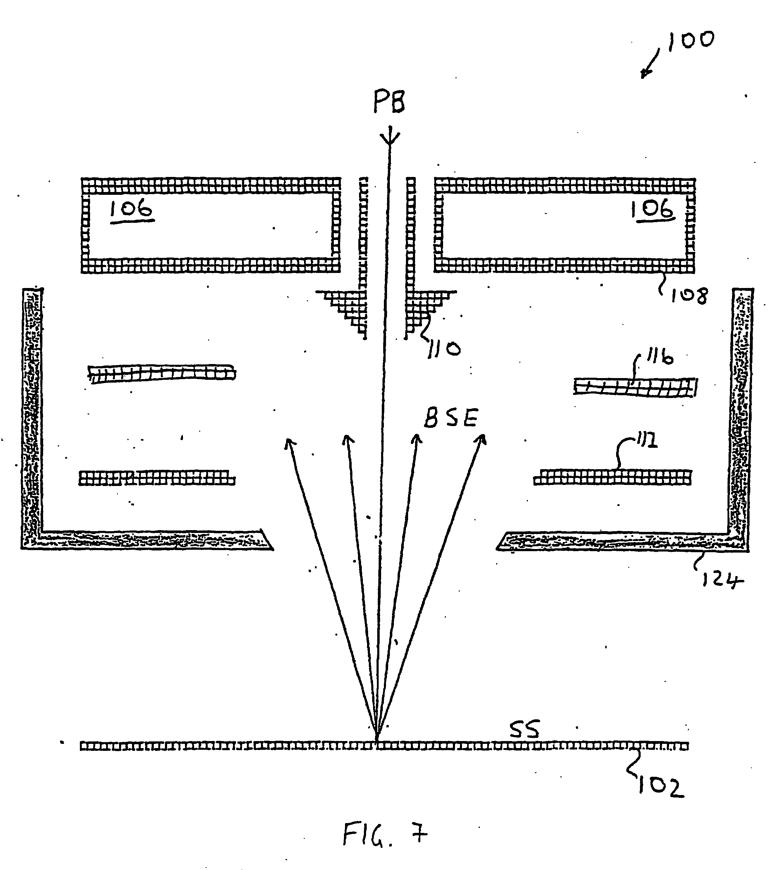

In certain applications, spacial care has to be taken to prevent the specimen from being effected by the electric field within electron detector **100** where such electric field may have deleterious effects on specimen **102** or on the functioning of other detectors in the particle beam apparatus. Shielding of specimen **102** can be achieved as shown in Figure 7 by providing an electrode **124** which is typically maintained at nearly the same potential as specimen **102**, thereby acting as a Faraday cage to confine the electric field within electron detector **100.**

As described earlier, Figure 8 shows a second configuration in which electron detector **100** is deployed within the optical column of particle beam apparatus **102**. In this case, the potentials of the elements of electron detector **100** are relative to the common potential of the optical column. The main difference between this configuration and the configuration shown in Figure 1 is that electromagnetic lenses EL accelerate secondary electrons released from specimen **102** towards electron detector **100** through increasing their kinetic energies by several thousand electron volts such that by the time they reach electron detector **100** they behave as if they were backscattered electrons. Therefore, this configuration of electron detector **100** provides high acceptance of both BSEs and SEs.

While the invention has been described with respect to a limited number of embodiments, it will be appreciated that many variations, modifications and other applications of the invention may be made within the sope of the appended claims.

Where technical features mentioned in any claim are followed by reference signs, those reference signs have been included for the sole purpose of increasing the intelligibility of the claims and accordingly, such reference signs do not have any limiting effect on the scope of each element identified by way of example by such reference signs.

## Claims

1. An electron detector (100) having a high backscattered electron acceptance of backscattered electrons emitted from a specimen (102), said electron detector comprising:
an electron multiplier (106) having an input surface (108) for collecting high energy backscattered electrons, said input surface (108) releasing secondary electrons on impingement of backscattered electrons thereon, said secondary electrons having trajectories away from said input surface (108);
a first electrode (112) deployed between said electron multiplier (106) and the specimen (102), said first electrode (112) being biased at a negative potential with respect to the specimen (102) so as to generate a first electric field for retarding low energy secondary electrons emitted by the specimen from reaching said electron multiplier (106), and thereby enabling passage of the high energy backscattered electrons emitted by the specimen (102) towards said electron multiplier (106);
**characterized by**
a second electrode (116) deployed between said electron multiplier (106) and said first electrode (112), said electrode (116) being biased at a negative potential with respect to said input surface (108) and spaced from said input surface (108) at a distance selected so as to generate a second electric field for substantially inverting the trajectories of said secondary electrons towards said input surface (108) such that said input surface (108) collects said secondary electrons.

2. The electron detector as in claim 1, wherein said first electrode (112) is annular having an aperture (114) selected for passing therethrough a predetermined solid angle of backscattered electrons for impingement on said electron multiplier (106).

3. The electron detector as in claim 1, wherein said second electrode (116) is annular having an aperture (118) selected for passing therethrough a predetermined solid angle of backscattered electrons for impingement on said electron multiplier (106).

4. An electron detector (100) having a high backscattered electron acceptance of backscattered electrons emitted from a specimen (102), said electron detector comprising:
(a) an electron multiplier (106) having an input surface (108) for collecting high energy backscattered electrons, said input surface (108) releasing secondary electrons on impingement backscattered electrons thereon, said secondary electrons having trajectories away from said input surface (108);
(b) an electrode (122) deployed between said electron multiplier (106) and the specimen (102), said electrode (122) being biased at a negative potential with respect to said input surface (108) and to the specimen (102), said electrode (122) generating a first electric field for retarding low energy secondary electrons emitted by the specimen (102) from reaching said electron multiplier (106), and thereby enabling passage of the high energy backscattered electrons emitted by the specimen towards said electron multiplier (106),
**characterized in that**
said electrode (122) is spaced from said input surface (108) at a distance selected so as to generate a second electric field for substantially inverting the trajectories of said secondary electrons towards said input surface (108) such that said input surface (108) collects said secondary electrons.

5. The electron detector as in claim 4, wherein said electrode (122) is annular having an aperture selected for passing therethrough a pre-determined solid angle of backscattered electrons for impingement on said electron multiplier (106).

6. The electron detector as in claim 1, further comprising a third electrode (124) deployed between said second electrode (116) and the specimen (102), said third electrode (124) having a potential so as to act as a Faraday cage for the electron detector (106).

7. The electron detector as in any of the preceding claims, further comprising a beam shielding tube (110) for the passage therethrough of a particle beam toward the specimen (102), the beam shielding tube (110) releasing secondary electrons on impingement of backscattered electrons thereon, said secondary electrons having trajectories away from said beam shielding tube (110), said second electric field substantially inverting the trajectories of said secondary electrons towards said input surface (108) such that said input surface (108) collects said secondary electrons released from the beam shielding tube (110).

8. The electron detector as in claim 7, wherein said beam shielding tube (110) has a beveled end.

9. The electron detector as in claim 7 or 8, wherein said beam shielding tube (110) is fabricated from a material having a secondary electron emission coefficient of greater than unity.

10. Particle beam apparatus including an electron detector (100) for detecting backscattered electrons emitted from a specimen (102) as claimed in any of claims 1 to 9.

## Patentansprüche

1. Ein Elektronen-Detektor (100) mit einer hohen Akzeptanz für Rückstreuelektronen, die von einer Probe (102) emittiert werden, mit
einem Elektronen-Vervielfacher (106) mit einer Eintrittsfläche (108), um Rückstreuelektronen mit hoher Energie zu sammeln, wobei die Eintrittsfläche (108) bei Aufprall von Rückstreuelektronen darauf Sekundärelektronen abgibt und die Sekundärelektronen Flugbahnen fort von der Eintrittsfläche haben;
einer ersten Elektrode (112) angeordnet zwischen dem Elektronen-Vervielfacher (106) und der Probe (102), wobei die erste Elektrode (112) auf einem negativen Potential bezüglich der Probe (102) liegt, um ein erstes elektrisches Feld zu erzeugen, das von der Probe emittierte Sekundärelektronen mit niedriger Energie vom Ereichen des Elektronen-Vervielfachers (106) abhält und dabei den Durchgang von von der Probe (102) emittierten Rückstreuelektronen mit hoher Energie in Richtung des Elektronen-Vervielfacher (106) ermöglicht;
**gekennzeichnet, durch**
eine zweite Elektrode (116) angeordnet zwischen dem Elektronen-Vervielfacher (106) und der ersten Elektrode (112), wobei die Elektrode (116) auf einem negativen Potential bezüglich der Eintrittsfläche (108) liegt und von der Eintrittsfläche (108) einen solchen Abstand hat, daß ein zweites elektrisches Feld erzeugt wird, um im Wesentlichen die Flugbahnen der Sekundärelektronen in Richtung der Eintrittsfläche (108) umzudrehen, so daß die Eintrittsfläche (108) die Sekundärelektronen sammelt.

2. Der Elektronen-Detektor (100) nach Anspruch 1, wobei die erste Elektrode (112) ring-förmig ist und eine Apertur (114) hat, die so gewählt ist, daß Sekundärelektronen diese unter einem festgelegten Raumwinkel zum Aufprall auf dem Elektronen-Vervielfacher (106) passieren.

3. Der Elektronen-Detektor (100) nach Anspruch 1, wobei die zweite Elektrode (116) ring-förmig ist und eine Apertur (118) hat, die so gewählt ist, daß Sekundärelektronen diese unter einem festgelegten Raumwinkel zum Aufprall auf dem Elektronen-Vervielfacher (106) passieren.

4. Ein Elektronen-Detektor (100) mit einer hohen Akzeptanz für Rückstreuelektronen, die von einer Probe (102) emittiert werden, mit
(a) einem Elektronen-Vervielfacher (106) mit einer Eintrittsfläche (108), um Rückstreuelektronen mit hoher Energie zu sammeln, wobei die Eintrittsfläche (108) bei Aufprall von Rückstreuelektronen darauf Sekundärelektronen abgibt und die Sekundärelektronen Flugbahnen fort von der Eintrittsfläche haben;
(b) einer Elektrode (122) angeordnet zwischen dem Elektronen-Vervielfacher (106) und der Probe (102) , wobei die Elektrode (122) bezüglich der Eintrittsfläche (108) und der Probe (102) auf einem negativen Potential liegt, die Elektrode (122) ein erstes elektrisches Feld erzeugt, das von der Probe emittierte Sekundärelektronen mit niedriger Energie vom Ereichen des Elektronen-Vervielfachers (106) abhält und dabei den Durchgang von von der Probe (102) emittierten Rückstreuelektronen mit hoher Energie in Richtung des Elektronen-Vervielfacher (106) ermöglicht;
**gekennzeichnet, durch**
die Elektrode (122) einen Abstand von der Eintrittsfläche (108) hat, der so gewählt ist, daß ein zweites elektrisches Feld erzeugt wird, um im Wesentlichen die Flugbahnen der Sekundärelektronen in Richtung der Eintrittsfläche (108) umzudrehen, so daß die Eintrittsfläche (108) die Sekundärelektronen sammelt.

5. Der Elektronen-Detektor (100) nach Ansprcuh 4, wobei die Elektrode (122) ringförmig ist und eine Apertur hat, die so gewählt ist, daß Sekundärelektronen diese unter einem festgelegten Raumwinkel zum Aufprall auf dem Elektronen-Vervielfacher (106) passieren.

6. Der Elektronen-Detektor (100) nach Anspruch 1, mit einer dritten Elektrode (124) angeordnet zwischen der zweite Elektrode (116) und der Probe (102), wobei die dritten Elektrode (124) ein solches Potential hat, daß sie als Faraday-Käfig für den Elektronen-Detektor (106) wirkt.

7. Der Elektronen-Detektor (100) nach einem der vorangegangenen Ansprüche, mit einer Strahl-Abschrimungs-Röhre (110) durch die der Teilchenstrahl in Richtung der Probe (102) passiert, wobei die Strahl-Abschrimungs-Röhre (110) beim Aufprall von Rückstreuelektronen darauf Sekundärelektronen abgibt, die Flugbahnen fort von der Strahl-Abschrimungs-Röhre (110) haben, wobei das zweites elektrisches Feld im Wesentlichen die Flugbahnen der Sekundärelektronen in Richtung der Eintrittsfläche (108) umdreht, so daß die Eintrittsfläche (108) die von der Strahl-Abschrimungs-Röhre (110) abgegebenen Sekundärelektronen sammelt.

8. Der Elektronen-Detektor (100) nach Anspruch 7, wobei die Strahl-Abschrimungs-Röhre (110) ein abgeschrägtes Ende hat.

9. Der Elektronen-Detektor (100) nach einem der Ansprüche 7 oder 8, wobei die Strahl-Abschrimungs-Röhre (110) aus einem Material gefertigt ist, das einen Sekundärelektronen-Emissionskoeffizient größer eins hat.

10. Ein Teilchenstrahl-Apparat mit einem Elektronen-Detektor (100) zur Detektion von Rückstreuelektronen, die von einer Probe (102) emittiert werden, gemäß einem der Ansprüche 1 bis 9.

## Revendications

1. Détecteur d'électrons (100) ayant une haute acceptation d'électrons rétrodiffusés vis-à-vis d'électrons rétrodiffusés émis à partir d'un échantillon (102), ledit détecteur d'électrons comprenant :
un multiplicateur d'électrons (106) ayant une surface d'entrée (108) pour collecter les électrons rétrodiffusés de forte énergie, ladite surface d'entrée (108) libérant des électrons secondaires lors de l'impact, sur celle-ci, d'électrons rétrodiffusés, lesdits électrons secondaires ayant des trajectoires s'éloignant de ladite surface d'entrée (108),
une première électrode (112) déployée entre ledit multiplicateur d'électrons (106) et l'échantillon (102), ladite première électrode (112) étant polarisée négativement par rapport à l'échantillon (102) de manière à générer un premier champ électrique pour retarder le moment où des électrons secondaires de faible énergie émis par l'échantillon atteignent ledit multiplicateur d'électrons (106), et ainsi permettre le passage des électrons rétrodiffusés à forte énergie émis par l'échantillon (102) vers ledit multiplicateur d'électrons (106), **caractérisé en ce que**
une seconde électrode (116) est déployée entre ledit multiplicateur d'électrons (106) et ladite première électrode (112), ladite électrode (116) étant polarisée négativement par rapport à ladite surface d'entrée (108) et espacée de ladite surface d'entrée (108) selon une distance choisie de manière à générer un second champ électrique pour sensiblement inverser les trajectoires desdits électrons secondaires vers ladite surface d'entrée (108) de sorte que ladite surface d'entrée (108) collecte lesdits électrons secondaires.

2. Détecteur d'électrons selon la revendication 1, dans lequel ladite première électrode (112) est un anneau ayant une ouverture (114) sélectionnée de manière à se laisser traverser par un angle solide prédéterminé d'électrons rétrodiffusés en vue de l'impact sur ledit multiplicateur d'électrons (106).

3. Détecteur d'électrons selon la revendication 1, dans lequel ladite seconde électrode (116) est un anneau ayant un ouverture (118) sélectionnée de manière à se laisser traverser par un angle solide prédéterminé d'électrons rétrodiffusés en vue de l'impact sur ledit multiplicateur d'électrons (106).

4. Détecteur d'électrons (100) ayant une haute acceptation d'électrons rétrodiffusés vis-à-vis d'électrons rétrodiffusés émis à partir d'un échantillon (102), ledit détecteur d'électrons comprenant :
un multiplicateur d'électrons (106) ayant une surface d'entrée (108) pour collecter les électrons rétrodiffusés de forte énergie, ladite surface d'entrée (108) libérant des électrons secondaires lors de l'impact, sur celle-ci, d'électrons rétrodiffusés, lesdits électrons secondaires ayant des trajectoires s'éloignant de ladite surface d'entrée (108),
une électrode (122) déployée entre ledit multiplicateur d'électrons (106) et l'échantillon (102), ladite électrode (122) étant polarisée négativement par rapport à ladite surface d'entrée (108) et à l'échantillon (102), ladite électrode (122) générant un premier champ électrique pour retarder le moment où des électrons secondaires de faible énergie émis par l'échantillon (102) atteignent ledit multiplicateur d'électrons (106), et ainsi permettre le passage des électrons rétrodiffusés à forte énergie émis par l'échantillon vers ledit multiplicateur d'électrons (106), **caractérisé en ce que**
ladite électrode (122) est espacée de ladite surface d'entrée (108) selon une distance sélectionnée de manière à générer un second champ électrique pour sensiblement inverser les trajectoires desdits électrons secondaires vers ladite surface d'entrée (108) de sorte que ladite surface d'entrée (108) collecte lesdits électrons secondaires.

5. Détecteur d'électrons selon la revendication 4, dans lequel ladite électrode (122) est un anneau ayant une ouverture sélectionnée de manière à se laisser traverser par un angle solide prédéterminé d'électrons rétrodiffusés en vue de l'impact sur ledit multiplicateur d'électrons (106).

6. Détecteur d'électrons selon la revendication 1, comprenant en outre une troisième électrode (124) déployée entre ladite seconde électrode (116) et l'échantillon (102), ladite troisième électrode (124) ayant un potentiel tel qu'elle agit comme une cage de Faraday pour le détecteur d'électrons (106).

7. Détecteur d'électrons selon l'une quelconque des revendications précédentes, comprenant en outre un tube de protection de faisceau (110) pour permettre le passage, à travers celui-ci, d'un faisceau de particules vers l'échantillon (102), le tube de protection de faisceau (110) libérant des électrons secondaires lors de l'impact, sur celle-ci, d'électrons rétrodiffusés, lesdits électrons secondaires ayant des trajectoires s'éloignant dudit tube de protection de faisceau (110), ledit second champ électrique inversant sensiblement les trajectoires desdits électrons secondaires vers ladite surface d'entrée (108) de sorte que ladite surface d'entrée (108) récupère lesdits électrons secondaires libérés depuis le tube de protection de faisceau (110).

8. Détecteur d'électrons selon la revendication 7, dans lequel ledit tube de protection de faisceau (110) a une extrémité biseautée.

9. Détecteur d'électrons selon la revendication 7 ou 8, dans lequel ledit tube de protection de faisceau (110) est fabriqué à partir d'un matériau ayant un coefficient d'émission d'électrons secondaires supérieur à l'unité.

10. Appareil à faisceau de particules comprenant un détecteur d'électrons (100) pour détecter les électrons =-rétrodiffusés émis par un échantillon (102) tel que revendiqué selon l'une quelconque des revendications 1 à 9.
